# EUROPEAN PATENT APPLICATION

(11) **EP 4 622 434 A1**
(43) Date of publication of application: **24.09.2025**
(21) Application number: 24744348.4
(22) Date of filing: 18.01.2024
(51) Int. Cl.: H10K 71/15

(54) **PEROVSKITE PRECURSOR SOLUTION, PEROVSKITE SOLAR CELL, PREPARATION METHOD THEREFOR, AND ELECTRIC DEVICE**

(30) Priority: 18.01.2023 CN 202310078516
(71) Applicant: Contemporary Amperex Technology Co., Limited, Ningde, Fujian 352100 (CN)
(72) Inventor: LIN, Xiangling, Ningde, Fujian 352100 (CN); SU, Shuojian, Ningde, Fujian 352100 (CN); LI, Hanfang, Ningde, Fujian 352100 (CN); LIU, Zhaohui, Ningde, Fujian 352100 (CN); ZHANG, Fan, Ningde, Fujian 352100 (CN); CHEN, Guodong, Ningde, Fujian 352100 (CN); GUO, Yongsheng, Ningde, Fujian 352100 (CN)
(74) Representative: Kraus & Lederer PartGmbB
(86) International application number: PCT/CN2024/072990
(87) International publication number: WO 2024/153176

(57) **Abstract**

This application relates to a perovskite precursor solution, a perovskite solar cell, a preparation method of perovskite solar cell, and an electric apparatus. A composition of the perovskite precursor solution includes a perovskite precursor material and a solvent. The solvent includes a first solvent and a second solvent. The above perovskite precursor solution facilitates preparation of high-quality perovskite film in combination with an air knife process.

## Description

### CROSS-REFERENCE TO RELATED APPLICATIONS

This application claims priority to Chinese Patent Application No. 2023100785167, filed on January 18, 2023 and entitled "PEROVSKITE PRECURSOR SOLUTION, PEROVSKITE SOLAR CELL, PREPARATION METHOD OF PEROVSKITE SOLAR CELL, AND ELECTRIC APPARATUS", which is incorporated herein by reference in its entirety.

### TECHNICAL FIELD

This application relates to the field of solar cell technology, in particular to a perovskite precursor solution, a perovskite solar cell, a preparation method of perovskite solar cell, and an electric apparatus.

### BACKGROUND

Perovskite solar cells (perovskite solar cells) are solar cells utilizing perovskite-type organic metal halide semiconductors as light-absorbing materials, belonging to the third generation of solar cells, also known as new-concept solar cells. A perovskite film serves as a main functional layer of perovskite solar cells.

Preparation of a perovskite film typically requires three processes: wet film coating, solvent quenching, and annealing. In device preparation, a spin-coating method is commonly used to apply a wet film, an anti-solvent is added dropwise for solvent quenching, and then annealing crystallization is performed under certain temperature and time conditions to form a perovskite film. However, perovskite films prepared using such method mostly suffer from the problem of poor film quality (compactness, flatness, or uniformity).

### SUMMARY

This application provides a perovskite precursor solution, a perovskite solar cell, a preparation method of perovskite solar cell, and an electric apparatus. A perovskite film in the perovskite solar cell has a uniform film layer and high quality.

According to a first aspect of this application, a perovskite solar cell is provided, including a transparent electrode, a first functional layer, a perovskite film, a second functional layer, and a second electrode layer arranged in a stacked manner, where a perovskite grain size distribution in the perovskite film is ≥ 1.2 µm.

In the perovskite solar cell provided by this application, the perovskite grain size distribution in the perovskite film is ≥ 1.2 µm, which is difficult to achieve by traditional processes, and accordingly, flatness of the perovskite film is significantly improved, thereby effectively improving battery efficiency.

In one embodiment, the perovskite grain size distribution in the perovskite film is ≥ 2 µm. Further, the perovskite grain size distribution in the perovskite film is 2 µm to 3 µm.

According to a second aspect of this application, a perovskite precursor solution is provided, with a composition including a perovskite precursor material and a solvent. The solvent includes a first solvent and a second solvent, satisfying one or more of the following (1) and (2):
(1) a boiling point of the first solvent is lower than a boiling point of the second solvent; optionally, an absolute value of a difference between the boiling point of the first solvent and the boiling point of the second solvent is ≥ 30; and further optionally, the absolute value of the difference between the boiling point of the first solvent and the boiling point of the second solvent is 50 to 150; and
(2) a saturated vapor pressure of the first solvent is higher than a saturated vapor pressure of the second solvent; optionally, the saturated vapor pressure of the first solvent is more than 8 times the saturated vapor pressure of the second solvent; and further optionally, the saturated vapor pressure of the first solvent is 10 to 300 times the saturated vapor pressure of the second solvent.

In this application, two solvents with different boiling points and/or different saturated vapor pressures are used in combination to adjust a process window, thereby adapting to an air knife process and achieving high-quality perovskite film preparation.

In one embodiment, the first solvent satisfies one or more of the following (1) and (2):
(1) the boiling point is 70°C to 160°C, and optionally, the boiling point is 75°C to 155°C; and
(2) the saturated vapor pressure is higher than 2 mm Hg at 20°C; and optionally, the saturated vapor pressure is 2.5 mm Hg to 200 mm Hg at 20°C.

In one embodiment, the second solvent satisfies one or more of the following (1) and (2):
(1) the boiling point is 130°C to 220°C, and optionally, the boiling point is 150°C to 210°C; and
(2) the saturated vapor pressure is lower than or equal to 3 mm Hg at 20°C; and optionally, a saturated vapor pressure is 0.2 mm Hg to 3 mm Hg at 20°C.

In one embodiment, a volume ratio of the first solvent to the second solvent is Y, where 20 ≥ Y ≥ 1.

In one embodiment, a solid content of the perovskite precursor solution is 10% to 40%; and optionally, the solid content of the perovskite precursor solution is 10% to 25%.

In one embodiment, the first solvent includes one or more of acetonitrile, dioxane, ethylene glycol monomethyl ether, and N'N-dimethylformamide.

In one embodiment, the second solvent includes one or more of N'N-dimethylformamide, N'N-diethylacetamide, N-methylpyrrolidone, dimethyl sulfoxide, and γ-butyrolactone.

In one embodiment, a general structural formula of the perovskite precursor material is ABX₃ or A₂CDX₆, where A is a monovalent cation, B is a divalent metal cation, C and D are a monovalent cation and a trivalent metal cation respectively, and X is a monovalent anion.

Optionally, A includes one or more of Cs⁺, K⁺, Rb⁺, monovalent amine cations, and monovalent amidinium cations.

Optionally, B includes one or more of Pb²⁺, Sn²⁺, Fe²⁺, Mn²⁺, Ni²+, Ge²⁺, Co²⁺, and Sb²⁺.

Optionally, C includes one or more of Cs⁺, Ag⁺, K⁺, and Ru⁺.

Optionally, D includes one or more of Bi³⁺, Ni³⁺, Fe³⁺, and Cu³⁺.

Optionally, X includes one or more of I-, Br-, and Cl-.

According to a third aspect of this application, a preparation method of perovskite solar cell is provided, including the following steps:
preparing a first functional layer on a surface of a transparent electrode;
preparing a perovskite film on a surface of the first functional layer;
preparing a second functional layer on a surface of the perovskite film; and
preparing a second electrode layer on a surface of the second functional layer.

The step of preparing a perovskite film on a surface of the first functional layer includes:
applying a perovskite precursor solution on the surface of the first functional layer through slit coating, and quenching a solvent in the perovskite precursor solution through an air knife process to form an intermediate-state film; where the perovskite precursor solution is the perovskite precursor solution described in the second aspect; and
annealing the intermediate-state film to prepare the perovskite film.

The above preparation method, based on the use of the above perovskite precursor solution, cooperates with an air knife process to quench the solvent in the perovskite precursor solution. Through solvent compatibility and control for the air knife process, preparation of a high-quality perovskite film can be synergistically achieved. Additionally, this preparation method is more suitable for industrial large-area perovskite film preparation.

In one embodiment, the volume ratio of the first solvent to the second solvent is Y, the slit coating and the air knife process are performed synchronously, and 20 ≥ Y ≥ 6, optionally, 15 ≥ Y ≥ 6.

In one embodiment, the preparation method of the perovskite film satisfies one or more of the following (1) to (4):
(1) along a coating direction of the slit coating, an air knife of the air knife process is located 5 cm to 30 cm behind a slit coating blade; and optionally, an air knife of the air knife process is located 10 cm to 20 cm behind a slit coating blade;
(2) a distance between an air knife blade of the air knife process and a surface of the first functional layer is 0.5 cm to 3 cm; optionally, a distance between the air knife blade of the air knife process and the surface of the first functional layer is 1 cm to 2 cm; and further optionally, the distance between the air knife blade of the air knife process and the surface of the first functional layer is 0.8 cm to 1.2 cm;
(3) an air knife pressure of the air knife process is 0.2 MPa to 4 MPa; optionally, the air knife pressure of the air knife process is 1 MPa to 4 MPa; further optionally, the air knife pressure of the air knife process is 2 MPa to 4 MPa; and
(4) a moving speed of the air knife of the air knife process and the slit coating blade is 5 mm/s to 80 mm/s; optionally, the moving speed of the air knife of the air knife process and the slit coating blade is 5 mm/s to 45 mm/s; and further optionally, the moving speed of the air knife of the air knife process and the slit coating blade is 15 mm/s to 25 mm/s.

In one embodiment, the volume ratio of the first solvent to the second solvent is Y, the slit coating and the air knife process are performed sequentially, and 6 ≥ Y ≥ 1, optionally, 4 ≥ Y ≥ 3.

In one embodiment, the preparation method of the perovskite film satisfies one or more of the following (1) to (3):
(1) a distance between the air knife blade of the air knife process and the surface of the first functional layer is 0.5 cm to 3 cm; optionally, the distance between the air knife blade of the air knife process and the surface of the first functional layer is 0.5 cm to 2 cm; and further optionally, the distance between the air knife blade of the air knife process and the surface of the first functional layer is 0.8 cm to 1.2 cm;
(2) an air knife pressure of the air knife process is 0.3 MPa to 6 MPa; optionally, the air knife pressure of the air knife process is 1 MPa to 6 MPa; further optionally, the air knife pressure of the air knife process is 2 MPa to 4 MPa; and
(3) a moving speed of the air knife of the air knife process and the slit coating blade is 5 mm/s to 80 mm/s; optionally, the moving speed of the air knife of the air knife process and the slit coating blade is 15 mm/s to 80 mm/s; and further optionally, the moving speed of the air knife of the air knife process and the slit coating blade is 25 mm/s to 55 mm/s.

According to a fourth aspect of this application, an electric apparatus is provided, including one or more of the perovskite solar cell described in the first aspect and a perovskite solar cell prepared using the preparation method described in the third aspect.

### BRIEF DESCRIPTION OF DRAWINGS

To more clearly illustrate technical solutions of the embodiments of this application, drawings required for use in the embodiments of this application are briefly introduced below. Obviously, the drawings described below are only some embodiments of this application, and persons of ordinary skill in the art can obtain other drawings based on the drawings without creative effort. In the accompanying drawings:
FIG. 1 is a schematic structural diagram of a perovskite solar cell prepared in an embodiment of this application, where 100. second electrode; 200. hole transport layer or electron transport layer; 300. perovskite body layer; 400. electron transport layer or hole transport layer; 500. first electrode; and 600. glass substrate;
FIG. 2 is a schematic flowchart of a process for preparing a perovskite film in an embodiment of this application, where 700. coating table; 800. prefabricated piece with hole transport layer NiOₓ; Q1. slit coating head; and Q2. air knife;
FIG. 3 is a morphology diagram of a coating formed after air knife crystallization (that is before annealing) in a process of preparing a perovskite film in Example 1-1 of this application;
FIG. 4 is a morphology diagram of a perovskite film prepared after annealing the coating in FIG. 3;
FIG. 5 is a morphology diagram of a perovskite film prepared in Example 2-1 of this application; and
FIG. 6 is a photograph of a perovskite film prepared in Example 1-1 of this application.

### DESCRIPTION OF EMBODIMENTS

The following discloses a perovskite precursor solution, a perovskite solar cell, a preparation method of perovskite solar cell, and an electric apparatus of this application in detail with appropriate reference to the accompanying drawings. However, unnecessary detailed descriptions may be omitted. For example, detailed descriptions of well-known matters and repeated descriptions of substantially identical structures may be omitted. This is to prevent the following description from becoming unnecessarily lengthy and to facilitate understanding by persons skilled in the art. Furthermore, the accompanying drawings and the following description are provided for persons skilled in the art to fully understand this application and are not intended to limit the subject matter recited in the claims.

"Ranges" disclosed in this application are defined in the form of lower and upper limits. A given range is defined by one lower limit and one upper limit selected, where the selected lower and upper limits define boundaries of that special range. Ranges defined in this manner may include or exclude endpoint values and may be arbitrarily combined, meaning any lower limit may be combined with any upper limit to form a range. For example, if ranges of 60-120 and 80-110 are listed for a specific parameter, ranges of 60-110 and 80-120 are also contemplated. Additionally, if minimum range values of 1 and 2 are listed, and if maximum range values of 3, 4, and 5 are listed, the following ranges are all contemplated: 1-3, 1-4, 1-5, 2-3, 2-4, and 2-5. In this application, unless otherwise specified, a numerical range "a-b" represents an abbreviated representation of any combination of real numbers between a and b, where a and b are both real numbers. For example, a numerical range "0-5" means that all real numbers between "0-5" have been fully listed herein, and "0-5" is merely an abbreviated representation of these numerical combinations. In addition, a parameter expressed as an integer greater than or equal to 2 is equivalent to disclosure that the parameter is, for example, an integer among 2, 3, 4, 5, 6, 7, 8, 9, 10, 11, 12, and so on.

Unless otherwise specified, all embodiments and optional embodiments of this application may be combined with each other to form new technical solutions.

Unless otherwise stated, all the technical features and optional technical features of this application can be combined with each other to form new technical solutions.

Unless otherwise specified, all steps of this application may be performed sequentially or randomly, and in some examples, are performed sequentially. For example, the method includes steps (a) and (b), indicating that the method may include steps (a) and (b) performed sequentially, or may include steps (b) and (a) performed sequentially. For example, mentioning that the method may further include step (c) indicates that step (c) may be added to the method in any order, for example, the method may include steps (a), (b), and (c), or may include steps (a), (c), and (b), or may include steps (c), (a), and (b), and so on.

Morphological features involved in this application can be obtained by existing equipment in the art, including but not limited to a scanning electron microscope (Scanning electron microscope, SEM) and an atomic force microscope (Atomic Force Microscope, AFM).

Currently, a common route in the preparation of large-area perovskite films is to form a wet film through slit coating, then use an air knife to blow or perform vacuum flashing to remove a large amount of solvent from the wet film to achieve a solvent quenching effect, and finally perform annealing and crystallization to form a perovskite film. Vacuum flashing has high equipment requirements, and the prepared dry film is prone to generation of shrinking holes or pinholes, leading to degraded device performance. Additionally, some methods comprehensively utilize air knife blowing or vacuum flashing for solvent quenching, but these methods still primarily rely on vacuum flashing, with air knife blowing merely as an auxiliary operation, and are still unable to avoid issues associated with vacuum flashing, with extra steps added. The traditional air knife blowing process has low adaptation costs and high production efficiency for large-area film preparation, but the traditional air knife blowing process struggles to control the formation of high-quality (compactness, flatness, or uniformity) perovskite films.

Based on this, in this application, through extensive research and experience summarization, it is found that the difficulty of the traditional air knife blowing process in forming high-quality perovskite films is closely related to a solvent composition in a perovskite precursor solution formulation, and the technical solution of this application is proposed for this.

An example of this application provides a perovskite solar cell, including a transparent electrode, a first functional layer, a perovskite film, a second functional layer, and a second electrode layer arranged in a stacked manner, where a perovskite grain size distribution in the perovskite film is ≥ 1.2 micrometers (µm).

Research has shown that a perovskite grain size distribution in a perovskite film prepared by the traditional air knife blowing process is typically less than 1 µm, whereas the perovskite grain size distribution in the perovskite film provided by this application is ≥ 1.2 µm, which is difficult to achieve by traditional processes, and accordingly, flatness of the perovskite film is significantly improved, thereby effectively improving battery efficiency.

Understandably, the perovskite grain size distribution in the perovskite film refers to a particle size corresponding to a cumulative particle size distribution percentage reaching 50% in a sample, with a largest particle size of a single perovskite grain taken during accumulation.

In some of these examples, the perovskite grain size distribution in the perovskite film is ≥ 2 µm. Further, the perovskite grain size distribution in the perovskite film is 2 µm to 3 µm.

In some of these examples, a surface of the perovskite film exhibits a white haze. Due to a large number of large-sized perovskite grains in the perovskite film provided by this application, a relatively obvious scattering phenomenon can occur, resulting in white haze on the surface. This indicates fewer grain defects, which can increase current and open-circuit voltage, thereby improving performance and lifespan of a perovskite module.

Another example of this application provides a perovskite precursor solution, with a composition including a perovskite precursor material and a solvent. The solvent includes a first solvent and a second solvent, satisfying one or more of the following (1) and (2):
(1) a boiling point of the first solvent is lower than a boiling point of the second solvent; and
(2) a saturated vapor pressure of the first solvent is higher than a saturated vapor pressure of the second solvent.

It is found through research that crystallization quality of a perovskite film is significantly related to a process window of a perovskite precursor solution. According to the perovskite crystal growth theory, to obtain a high-quality perovskite film, rapid nucleation must occur in a short period, meaning that when an appropriate amount of crystal nuclei exist in the system, the solvent must be quickly removed to allow existing crystal seeds to grow without generating additional crystal nuclei, reducing dendrite formation (in perovskite devices, dense and flat large grains exhibit excellent performance, while excessive crystal nuclei lead to disordered dendrite formation; since solute in the solution is limited, if solute transforms into crystal nuclei, components available for nucleus growth decrease, making it difficult to produce large-sized grains). If a process window in the system is too short, excessive crystal nuclei form dendrites before solvent quenching, reducing crystallization quality of the perovskite film; if a process window is too long, requirements for solvent quenching are higher. Therefore, the process window needs reasonable adjustment, and the process window of the perovskite precursor solution can be adjusted by varying proportions of solvents with different boiling points and/or saturated vapor pressures. Thus, in this application, two solvents with different boiling points and/or saturated vapor pressures are used in combination to adjust the process window, thereby adapting to an air knife process and achieving preparation of a high-quality perovskite film.

Further, the perovskite precursor solution is actually a colloid, where the perovskite precursor material and the solvent exist in a complexed form, so the boiling point and the saturated vapor pressure of the solvent directly affect a crystal nucleus formation rate.

In some of these examples, an absolute value of a difference between the boiling point of the first solvent and the boiling point of the second solvent is ≥ 30. Further, the absolute value of the difference between the boiling point of the first solvent and the boiling point of the second solvent is 50 to 150. Specifically, the absolute value of the difference between the boiling point of the first solvent and the boiling point of the second solvent includes but is not limited to: 50, 55, 60, 65, 67.68, 70, 71.4, 75, 77.5, 80, 85, 90, 95, 100, 105, 107.4, 110, 115, 120, 121.4, 125, 130, 135, 140, 145, 150, or a range defined by any two of these values. Reasonably controlling the difference between the boiling point of the first solvent and the boiling point of the second solvent can achieve higher energy conversion efficiency.

In some of these examples, the saturated vapor pressure of the first solvent is more than 8 times the saturated vapor pressure of the second solvent. Further, the saturated vapor pressure of the first solvent is 10 to 200 times the saturated vapor pressure of the second solvent. Specifically, a multiple of the saturated vapor pressure of the first solvent to the saturated vapor pressure of the second solvent includes but is not limited to: 10, 15, 20, 25, 30, 35, 40, 45, 50, 80, 100, 120, 150, 160, 170, 180, 200, and 300. Reasonably controlling the multiple value between the saturated vapor pressure of the first solvent and the saturated vapor pressure of the second solvent can achieve higher energy conversion efficiency.

In some of these examples, the boiling point of the first solvent is 70 degrees Celsius (°C) to 160°C. Specifically, the boiling point of the first solvent includes but is not limited to: 70°C, 75°C, 80°C, 81.6°C, 85°C, 90°C, 95°C, 100°C, 101.32°C, 105°C, 110°C, 115°C, 120°C, 124.5°C, 125°C, 130°C, 135°C, 140°C, 145°C, 150°C, 155°C, 160°C, or a range defined by any two of these values. Further, the boiling point of the first solvent is 75°C to 155°C.

In some of these examples, the saturated vapor pressure of the first solvent is higher than 2 millimeters of mercury (mm Hg) at 20°C. Further, the saturated vapor pressure of the first solvent at 20°C is 2.5 mm Hg to 200 mm Hg. Specifically, the saturated vapor pressure of the first solvent at 20°C includes but is not limited to: 2.5 mm Hg, 5 mm Hg, 7 mm Hg, 10 mm Hg, 15 mm Hg, 20 mm Hg, 25 mm Hg, 30 mm Hg, 30 mm Hg, 50 mm Hg, 70 mm Hg, 80 mm Hg, 100 mm Hg, 120 mm Hg, 130 mm Hg, 150 mm Hg, 170 mm Hg, and 200 mm Hg.

In some of these examples, the boiling point of the second solvent is 130°C to 220°C. Specifically, the boiling point of the second solvent includes but is not limited to: 130°C, 135°C, 140°C, 145°C, 150°C, 155°C, 160°C, 165°C, 170°C, 175°C, 180°C, 185°C, 190°C, 195°C, 200°C, 205°C, 210°C, 215°C, 220°C, or a range defined by any two of these values. Further, the boiling point of the second solvent is 150°C to 210°C.

In some of these examples, the saturated vapor pressure of the second solvent is lower than or equal to 3 mm Hg at 20°C. Further, the saturated vapor pressure of the second solvent at 20°C is 0.2 mm Hg to 3 mm Hg. Specifically, the saturated vapor pressure of the second solvent at 20°C includes but is not limited to: 0.2 mm Hg, 0.3 mm Hg, 0.4 mm Hg, 0.5 mm Hg, 0.6 mm Hg, 0.7 mm Hg, 0.8 mm Hg, 0.9 mm Hg, 1 mm Hg, 1.1 mm Hg, 1.2 mm Hg, 1.3 mm Hg, 1.4 mm Hg, 1.5 mm Hg, 1.6 mm Hg, 1.7 mm Hg, 1.8 mm Hg, 1.9 mm Hg, 2 mm Hg, 2.1 mm Hg, 2.2 mm Hg, 2.3 mm Hg, 2.4 mm Hg, 2.5 mm Hg, 2.6 mm Hg, 2.7 mm Hg, 2.8 mm Hg, 2.9 mm Hg, 3 mm Hg, or a range defined by any two of these values.

Further, a higher proportion of a solvent (the second solvent) with a higher boiling point and lower saturated vapor pressure results in slower crystal nucleus formation and a longer process window. However, if the proportion of the solvent (the second solvent) with a higher boiling point and lower saturated vapor pressure is too high, air pressure required by the air knife process increases as well, resulting in a difficulty in performing uniform solvent quenching, so a balance is required between the two as required.

In some of these examples, the volume ratio of the first solvent to the second solvent is Y, where 20 ≥ Y ≥ 1. Specifically, a value of Y includes but is not limited to: 1, 2, 3, 4, 5, 6, 7, 8, 9, 10, 11, 12, 13, 14, 15, 16, 17, 18, 19, 20, or a range defined by any two of these values. Reasonably controlling the volume ratio of the first solvent to the second solvent facilitates uniform film formation of the perovskite film, thereby achieving higher energy conversion efficiency.

In some of these examples, a solid content of the perovskite precursor solution is 10% to 40%. Specifically, the solid content of the perovskite precursor solution includes but is not limited to: 10%, 15%, 18%, 20%, 25%, 30%, 35%, 40%, or a range defined by any two of these values. Further, the solid content of the perovskite precursor solution is 10% to 25%. Reasonably controlling the solid content of the perovskite precursor solution can achieve higher energy conversion efficiency.

Specifically, the first solvent includes one or more of acetonitrile, dioxane, ethylene glycol monomethyl ether, and N'N-dimethylformamide (DMF).

Specifically, the second solvent includes one or more of N,N-dimethylformamide (N,N-Dimethylformamide, DMF), N,N-diethylacetamide (N,N-Diethylacetamide, DMAC), N-methylpyrrolidone (N-methylpyrrolidone, NMP), dimethyl sulfoxide (Dimethylsulfoxide, DMSO), and γ-butyrolactone (Gamma-butyrolactone, GBL).

Specifically, the perovskite precursor material may be a conventional material type in the art. Without limitation, a general structural formula of the perovskite precursor material is ABX₃ or A₂CDX₆, where A is a monovalent cation, B is a divalent metal cation, C and D are a monovalent cation and a trivalent metal cation respectively, and X is a monovalent anion.

Without limitation, A includes one or more of Cs⁺, K⁺, Rb⁺, monovalent amine cations, and monovalent amidinium cations.

Without limitation, B includes one or more of Pb²⁺, Sn²⁺, Fe²⁺, Mn²⁺, Ni²⁺, Ge²⁺, Co²⁺, and Sb²⁺.

Without limitation, C includes one or more of Cs⁺, Ag⁺, K⁺, and Ru⁺.

Without limitation, D includes one or more of Bi³⁺, Ni³⁺, Fe³⁺, and Cu³⁺.

Without limitation, X includes one or more of I-, Br-, and Cl-.

Another example of this application provides a preparation method of perovskite solar cell, including the following steps:
preparing a first functional layer on a surface of a transparent electrode;
preparing a perovskite film on a surface of the first functional layer;
preparing a second functional layer on a surface of the perovskite film; and
preparing a second electrode layer on a surface of the second functional layer;

The step of preparing a perovskite film on a surface of the first functional layer includes:
applying a perovskite precursor solution on the surface of the first functional layer through slit coating, and quenching a solvent in the perovskite precursor solution through an air knife process to form an intermediate-state film; where the perovskite precursor solution is the perovskite precursor solution as described above; and
annealing the intermediate-state film to prepare the perovskite film.

The above preparation method, based on the use of the above perovskite precursor solution, cooperates with an air knife process to quench the solvent in the perovskite precursor solution. Through solvent compatibility and control for the air knife process, high-quality perovskite film preparation can be synergistically achieved. Additionally, this preparation method is more suitable for industrial large-area perovskite film preparation.

Further, to better synergize with solvent compatibility for achieving high-quality perovskite film preparation, uniformity of air output in the air knife process needs to be controlled. The uniformity of air output of the air knife is mainly affected by the following factors: whether the air knife moves with a slit coating blade (or moves independently), a position of the air knife installation distance from the slit coating blade (when the air knife moves with the slit coating blade), a distance from the air knife to a coating substrate surface, air pressure, air knife moving speed, and the like.

Air knife process can be divided into two types: the first type is where slit coating and the air knife process are performed synchronously, meaning a slit coating blade and an air knife of the air knife process move synergistically, with the air knife being stationary relative to the slit coating blade and the air knife being located a certain distance behind the slit coating blade; the second type is where slit coating and the air knife process are performed sequentially, meaning the air knife process is performed after slit coating is completed, with the slit coating blade and the air knife of the air knife process moving independently. It is found in research that, to achieve high-quality perovskite film preparation, the two types of processes differ in requirements for solvent compatibility.

In some of these examples, the volume ratio of the first solvent to the second solvent is Y, the slit coating and the air knife process are performed synchronously, and 20 ≥ Y ≥ 6. Specifically, a value of Y includes but is not limited to: 6, 7, 8, 9, 10, 11, 12, 13, 14, 15, 16, 17, 18, 19, 20, or a range defined by any two of these values. Further, Y is 6 to 15. When the slit coating and the air knife process are performed synchronously, a shorter process window time is required (typically less than 10 seconds), and under the above Y conditions, solvent quenching can be quickly achieved while higher energy conversion efficiency is achieved.

Further, when the slit coating and the air knife process are performed synchronously, parameter settings satisfy:
in some of these examples, along a coating direction of the slit coating, the air knife of the air knife process is located 5 centimeters (cm) to 30 cm behind the slit coating blade. Specifically, the position where the air knife of the air knife process is located behind the slit coating blade includes but is not limited to: 5 cm, 10 cm, 15 cm, 20 cm, 25 cm, 30 cm, or a range defined by any two of these values. Further, the air knife of the air knife process is located 10 cm to 20 cm behind the slit coating blade. Reasonably controlling this process parameter can achieve higher energy conversion efficiency.

In some of these examples, a distance between the air knife blade of the air knife process and the surface of the first functional layer is 0.5 cm to 3 cm; and specifically, the distance between the air knife blade of the air knife process and the surface of the first functional layer includes but is not limited to: 0.5 cm, 0.8 cm, 1 cm, 1.2 cm, 1.5 cm, 2 cm, 2.5 cm, 3 cm, or a range defined by any two of these values. Further, the distance between the air knife blade of the air knife process and the surface of the first functional layer is 1 cm to 2 cm. Furthermore, the distance between the air knife blade of the air knife process and the surface of the first functional layer is 0.8 cm to 1.2 cm. Reasonably controlling this process parameter can achieve higher energy conversion efficiency.

In some of these examples, an angle between the air knife of the air knife process and the surface of the first functional layer is not particularly limited and may be set according to equipment, for example, typically set to 90° ± 30°.

In some of these examples, the air knife pressure of the air knife process is 0.2 megapascals (MPa) to 4 MPa. Specifically, the air knife pressure of the air knife process includes but is not limited to: 0.2 MPa, 0.5 MPa, 1 MPa, 1.5 MPa, 2 MPa, 2.5 MPa, 3 MPa, 3.5 MPa, 4 MPa, or a range defined by any two of these values. Further, the air knife pressure of the air knife process is 1 MPa to 4 MPa. Furthermore, the air knife pressure of the air knife process is 2 MPa to 4 MPa. Reasonably controlling this process parameter can achieve higher energy conversion efficiency.

In some of these examples, a moving speed of the air knife of the air knife process and the slit coating blade is 5 millimeters per second (mm/s) to 80 mm/s. Specifically, the moving speed of the air knife of the air knife process and the slit coating blade includes but is not limited to: 5 mm/s, 10 mm/s, 15 mm/s, 20 mm/s, 25 mm/s, 30 mm/s, 35 mm/s, 40 mm/s, 45 mm/s, 50 mm/s, 55 mm/s, 60 mm/s, 65 mm/s, 70 mm/s, 75 mm/s, 80 mm/s, or a range defined by any two of these values. Further, the moving speed of the air knife of the air knife process and the slit coating blade is 5 mm/s to 45 mm/s. Furthermore, the moving speed of the air knife of the air knife process and the slit coating blade is 15 mm/s to 25 mm/s. Reasonably controlling this process parameter can achieve higher energy conversion efficiency.

In some of these examples, the volume ratio of the first solvent to the second solvent is Y, the slit coating and the air knife process are performed sequentially, and 6 ≥ Y ≥ 1. Specifically, a value of Y includes but is not limited to: 1, 2, 3, 4, 5, 6, or a range defined by any two of these values. Further, 4 ≥ Y ≥ 3. When the slit coating and the air knife process are performed sequentially, a longer process window time is required, and under the above Y conditions, a perovskite precursor can be prevented from forming dendrites too quickly while higher energy conversion efficiency is achieved.

Further, when the slit coating and the air knife process are performed sequentially, parameter settings satisfy:
in some of these examples, a distance between the air knife blade of the air knife process and a coating substrate surface is 0.5 cm to 3 cm; and specifically, the distance between the air knife blade of the air knife process and the surface of the first functional layer includes but is not limited to: 0.5 cm, 0.8 cm, 1 cm, 1.2 cm, 1.5 cm, 2 cm, 2.5 cm, 3 cm, or a range defined by any two of these values. Further, the distance between the air knife blade of the air knife process and the surface of the first functional layer is 0.5 cm to 2 cm. Furthermore, the distance between the air knife blade of the air knife process and the surface of the first functional layer is 0.8 cm to 1.2 cm. Reasonably controlling this process parameter can achieve higher energy conversion efficiency.

In some of these examples, an angle between the air knife of the air knife process and the surface of the first functional layer is not particularly limited and may be set according to equipment, for example, typically set to 90° ± 30°.

In some of these examples, the air knife pressure of the air knife process is 0.3 MPa to 6 MPa. Specifically, the air knife pressure of the air knife process includes but is not limited to: 0.3 MPa, 0.5 MPa, 1 MPa, 1.5 MPa, 2 MPa, 2.5 MPa, 3 MPa, 3.5 MPa, 4 MPa, 4.5 MPa, 5 MPa, 5.5 MPa, 6 MPa, or a range defined by any two of these values. Further, the air knife pressure of the air knife process is 1 MPa to 6 MPa. Furthermore, the air knife pressure of the air knife process is 2 MPa to 4 MPa. Reasonably controlling this process parameter can achieve higher energy conversion efficiency.

In some of these examples, a moving speed of the air knife of the air knife process and the slit coating blade is 5 mm/s to 80 mm/s. Specifically, the moving speed of the air knife of the air knife process and the slit coating blade includes but is not limited to: 5 mm/s, 10 mm/s, 15 mm/s, 20 mm/s, 25 mm/s, 30 mm/s, 35 mm/s, 40 mm/s, 45 mm/s, 50 mm/s, 55 mm/s, 60 mm/s, 65 mm/s, 70 mm/s, 75 mm/s, 80 mm/s, or a range defined by any two of these values. Further, the moving speed of the air knife of the air knife process and the slit coating blade is 15 mm/s to 80 mm/s. Furthermore, the moving speed of the air knife of the air knife process and the slit coating blade is 25 mm/s to 55 mm/s. Reasonably controlling this process parameter can achieve higher energy conversion efficiency.

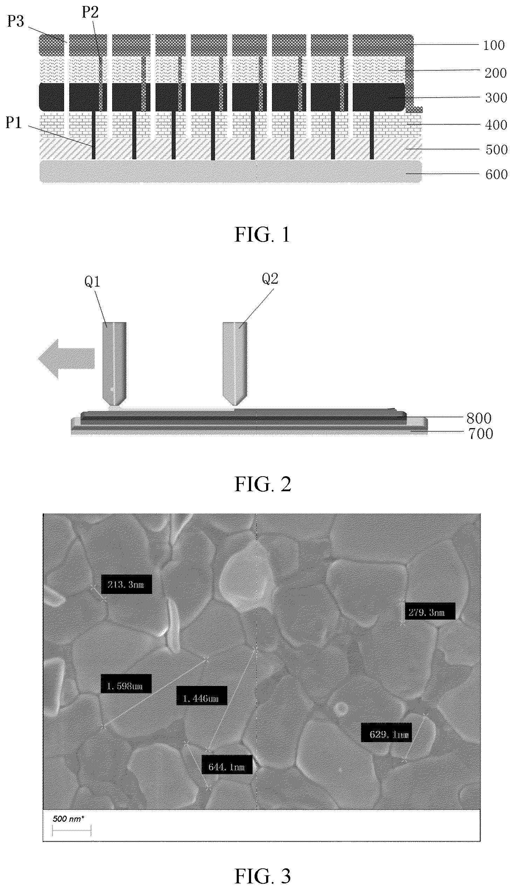

Understandably, perovskite solar cells include normal perovskite solar cells and inverted perovskite solar cells. As shown in FIG. 1, a first electrode 500, an electron transport layer or hole transport layer 400, a perovskite body layer 300, a hole transport layer or electron transport layer 200, and a second electrode 100 sequentially stacked on a glass substrate 600 are included. A normal perovskite solar cell includes a transparent electrode, as well as an electron transport layer, a perovskite body layer, a hole transport layer, and a second electrode sequentially stacked on the transparent electrode. An inverted perovskite solar cell includes a transparent electrode, as well as a hole transport layer, a perovskite body layer, an electron transport layer, and a second electrode sequentially stacked on the transparent electrode. The transparent electrode is configured for light incidence.

Without limitation, the electron transport layer may be made of one or more of the following materials and derivatives thereof: imide compound, quinone compound, fullerene and derivative thereof, methoxytriphenylamine-fluorinated formamidine (OMeTPA-FA), calcium titanate (CaTiO₃), lithium fluoride (LiF), calcium fluoride (CaF₂), poly(3,4-ethylenedioxythiophene):polystyrene sulfonate (PEDOT:PSS), poly-3-hexylthiophene (P3HT), triphenylamine (H101) using triptycene as core, 3,4-ethylenedioxythiophene-methoxytriphenylamine (EDOT-OMeTPA), N-(4-aniline)carbazole-spirobifluorene (CzPAF-SBF), polythiophene, metal oxide (with a metal element selected from Mg, Ni, Cd, Zn, In, Pb, Mo, W, Sb, Bi, Cu, Hg, Ti, Ag, Mn, Fe, V, Sn, Zr, Sr, Ga, or Cr), silicon oxide (SiO₂), strontium titanate (SrTiO₃), and copper thiocyanate (CuSCN).

Without limitation, the hole transport layer may be made of one or more of the following materials and derivatives thereof: 2,2',7,7'-tetra[N,N-di(4-methoxyphenyl)amino]-9,9'-spirobifluorene (Spiro-OMeTAD), polytriarylamine (PTAA), NiOx, poly(3,4-ethylenedioxythiophene):polystyrene sulfonate (PEDOT:PSS), WO₃, and other materials capable of transporting holes and blocking electrons.

Without limitation, the second electrode layer is made of a conductive material that is organic, inorganic, or a mixture of both in varying proportions, for example, a metal conductive material such as gold Au, silver Ag, copper Cu, aluminum Al, nickel Ni, chromium Cr, bismuth Bi, platinum Pt, magnesium Mg or a mixture thereof, and conductive oxide glass such as FTO, ITO and aluminum-doped zinc oxide AZO.

Without limitation, the transparent electrode may be made of a material, for example, FTO, ITO, AZO, BZO, and IZO.

Without limitation, the transparent electrode further includes a base layer. Specifically, the base layer is a flexible base layer, made of, for example, an organic polymer material, which may be one or a mixture of more of the following materials mixed in varying proportions: polyvinyl alcohol (PVA), polyester (PET), polyimide (PI), polyethylene naphthalate (PEN), and polydimethylsiloxane (PDMS).

Specifically, the perovskite solar cell is a normal perovskite solar cell, and a preparation method thereof includes the following steps:
Step 1: etch and clean a transparent electrode, and perform drying;
Step 2: prepare an electron transport layer on the transparent electrode;
Step 3: prepare the perovskite film on the electron transport layer;
Step 4: prepare a hole transport layer on the perovskite layer; and
Step 5: prepare a second electrode layer on the hole transport layer.

Specifically, the perovskite solar cell is an inverted perovskite solar cell, and a preparation method thereof includes the following steps:
Step 1: etch and clean a transparent electrode, and perform drying;
Step 2: prepare a hole transport layer on the transparent electrode;
Step 3: prepare the perovskite film on the electron transport layer;
Step 4: prepare an electron transport layer on the perovskite layer; and
Step 5: prepare a second electrode layer on the hole transport layer.

This application provides an electric apparatus, including one or more of the perovskite solar cell described above and a perovskite solar cell prepared using the preparation method of the solar cell described above.

In some embodiments, the solar cell described above can be used as a power source for an electric apparatus or as an energy storage unit for an electric device.

Further, the electric apparatus may include a mobile device such as a mobile phone and a notebook computer, an electric vehicle, an electric train, a ship, a satellite, an energy storage system, and the like, but is not limited thereto. The electric vehicle may be a battery electric vehicle, a hybrid electric vehicle, a plug-in hybrid electric vehicle, or the like.

In another example, the electric apparatus may be a mobile phone, a tablet computer, a notebook computer, or the like.

The following describes examples of this application. The examples described below are exemplary and are only used to explain this application, and should not be construed as limitation on this application. For examples where specific techniques or conditions are not specified, procedures are conducted according to techniques or conditions described in the literature in the art or according to product specifications. The reagents or instruments used are all conventional products that are commercially available if no manufacturer is indicated.

### Preparation Examples

A specification of a perovskite solar cell prepared was 300 mm * 300 mm.

### [Preparation of first electrode of assembly]

(1) A group of FTO conductive glass with a specification of 300 mm * 300 mm was etched using infrared laser for P1, with a width of P1 being approximately 30 µm; and the entire piece of glass was divided into 44 sub-cells sequentially along a long side direction, with a series resistance between different sub-cells being higher than 10 MΩ, where 10 mm of portions on top and bottom were taken as welding regions for the assembly.
(2) A surface of the etched conductive glass was cleaned twice sequentially with acetone and isopropanol, immersed in deionized water for ultrasonic treatment for 10 min, dried in an air-blowing drying oven, and then placed in a drying room (with a humidity below 2%) to serve as a first electrode.

### [Preparation of hole transport layer of assembly: nickel oxide layer]

(3) The cleaned conductive glass was placed in magnetron sputtering, with a hole transport layer NiOₓ deposited, where a thickness of a nickel oxide layer was approximately 15 nm.

### [Preparation of perovskite film of assembly]

(4) Perovskite precursor solutions with different solvent proportions and solvent types were prepared according to Tables 1 and 2 below, with a solute of 1.1 M FA_{0.95}Cs_{0.05}PbI₃.

(5) The above perovskite precursor solutions were respectively applied through slit coating to form a perovskite wet film on a surface of the hole transport layer NiOₓ, and solvent quenching was performed using two different air knife processes according to air knife process parameters in Tables 1 and 2 (Table 1 - coating and air knife blowing were performed synchronously, and Table 2 - air knife blowing was performed after coating), followed by annealing at 110°C for 20 min to obtain a perovskite film, that was, a perovskite absorption layer. The process is shown in FIG. 2, where a prefabricated piece 800 with the hole transport layer NiOₓ was placed on a surface of a coating table 700, the above perovskite precursor solution was applied using a slit coating head Q1 to form a perovskite wet film, and solvent quenching was performed using an air knife Q2.

### [Preparation of charge transport layer of assembly]

(6) A substrate with a prepared perovskite absorption layer was placed in a vacuum thermal evaporation device, with the device evacuated to 4 * 10⁻⁴ Pa, and 30 nm of C60 and 8 nm of BCP deposited as a charge transport layer of the assembly.

### [Preparation of second electrode of assembly]

(7) After depositing of the charge transport layer in the vacuum thermal evaporation device, 10 nm of Ag further deposited on a surface thereof; then vacuum was broken and the substrate was removed, followed by laser etching performed on P2, where a P2 width was 150 µm, P2 was etched to a depth reaching an FTO layer, and a spacing between P2 and P1 was 20 µm; then the substrate was placed back into the evaporation device; the device was evacuated to 4 * 10⁻⁴ Pa; and a layer of Ag with a thickness of approximately 80 nm further deposited.

(8) After cooling, vacuum was broken, and the substrate was removed for P seconds; and green laser etching was performed on P3, where a P3 width was 15 µm, P3 was etched to a depth reaching the FTO layer, and a spacing between P3 and P2 was 20 µm (etching line positions were sequentially P1/P2/P3).

(9) Then, infrared edge cleaning was performed on the assembly. To be specific, two sides of the assembly are respectively etched by 10 mm.

### Test Examples

### 1. Performance test of perovskite solar cell assembly

A performance test was conducted on perovskite solar cell assemblies prepared in examples and comparative examples.

Energy conversion efficiency of each assembly was tested under a solar simulator with 1000 W/m². Specifically, at normal temperature and normal pressure, a solar simulator light source with an AM1.5G standard was used, and a four-channel digital source meter (Keithley 2440) was used to measure a volt-ampere characteristic curve of the assembly under light source irradiation, to obtain an open-circuit voltage Voc, a short-circuit current density Jsc, and a fill factor FF (Fill Factor) of the assembly, thereby obtaining an energy conversion efficiency Eff (Efficiency) of the assembly, with results thereof converted to a single cell and recorded in Tables 1 and 2 below.

**Table 1 Coating and air knife blowing performed synchronously**

| | First solvent | Second solvent | Y | Solid content | Distance X1 | Distance X2 | Air knife pressure | Moving speed of air knife and coating blade | Air knife angle | Jsc (mA/cm²) | Voc (V) | FF (%) | PCE (%) |
|---|---|---|---|---|---|---|---|---|---|---|---|---|---|
| Example 1-1 | Acetonitrile | N'N-dimethylformamide | 10 | 18% | 15 cm | 1 cm | 2 MPa | 20 mm/s | 90° | 22.82 | 1.1 | 81.17 | 20.38 |
| Example 1-2 | Dioxane | N'N-diethylacetamide | 10 | 18% | 15 cm | 1 cm | 2 MPa | 20 mm/s | 90° | 20.53 | 1.09 | 80.21 | 17.93 |
| Example 1-3 | Ethylene glycol monomethyl ether | N-methylpyrrolidone | 10 | 18% | 15 cm | 1 cm | 2 MPa | 20 mm/s | 90° | 19.71 | 1.08 | 76.03 | 16.13 |
| Example 1-4 | Acetonitrile | Dimethyl sulfoxide | 10 | 18% | 15 cm | 1 cm | 2 MPa | 20 mm/s | 90° | 21.96 | 1.14 | 78.11 | 19.55 |
| Example 1-5 | N'N-dimethylformamide | γ-butyrolactone | 10 | 18% | 15 cm | 1 cm | 2 MPa | 20 mm/s | 90° | 21.02 | 1.04 | 69.38 | 15.11 |
| Example 1-6 | Acetonitrile | N'N-dimethylformamide | 20 | 18% | 15 cm | 1 cm | 2 MPa | 20 mm/s | 90° | 15.66 | 1.03 | 52.37 | 8.44 |
| Example 1-7 | Acetonitrile | N'N-dimethylformamide | 6 | 18% | 15 cm | 1 cm | 2 MPa | 20 mm/s | 90° | 21.78 | 1.08 | 72.68 | 17.1 |
| Example 1-8 | Acetonitrile | N'N-dimethylformamide | 8 | 18% | 15 cm | 1 cm | 2 MPa | 20 mm/s | 90° | 21.99 | 1.09 | 77.91 | 18.67 |
| Example 1-9 | Acetonitrile | N'N-dimethylformamide | 12 | 18% | 15 cm | 1 cm | 2 MPa | 20 mm/s | 90° | 21.19 | 1.07 | 70.17 | 15.91 |
| Example 1-10 | Acetonitrile | N'N-dimethylformamide | 15 | 18% | 15 cm | 1 cm | 2 MPa | 20 mm/s | 90° | 19.93 | 1.05 | 63.11 | 13.2 |
| Example 1-11 | Acetonitrile | N'N-dimethylformamide | 10 | 40% | 15 cm | 1 cm | 2 MPa | 20 mm/s | 90° | 16.77 | 0.99 | 71.22 | 11.82 |
| Example 1-12 | Acetonitrile | N'N-dimethylformamide | 10 | 10% | 15 cm | 1 cm | 2 MPa | 20 mm/s | 90° | 20.01 | 1.06 | 70.65 | 14.99 |
| Example 1-13 | Acetonitrile | N'N-dimethylformamide | 10 | 15% | 15 cm | 1 cm | 2 MPa | 20 mm/s | 90° | 19.25 | 1.07 | 73.41 | 15.12 |
| Example 1-14 | Acetonitrile | N'N-dimethylformamide | 10 | 20% | 15 cm | 1 cm | 2 MPa | 20 mm/s | 90° | 22.01 | 1.09 | 79.11 | 18.98 |
| Example 1-15 | Acetonitrile | N'N-dimethylformamide | 10 | 25% | 15 cm | 1 cm | 2 MPa | 20 mm/s | 90° | 19.02 | 1.05 | 74.11 | 14.80 |
| Example 1-16 | Acetonitrile | N'N-dimethylformamide | 10 | 30% | 15 cm | 1 cm | 2 MPa | 20 mm/s | 90° | 17.87 | 1.02 | 69.51 | 12.67 |
| Example 1-17 | Acetonitrile | N'N-dimethylformamide | 10 | 18% | 30 cm | 1 cm | 2 MPa | 20 mm/s | 90° | 18.96 | 1.13 | 61.89 | 13.26 |
| Example 1-18 | Acetonitrile | N'N-dimethylformamide | 10 | 18% | 5 cm | 1 cm | 2 MPa | 20 mm/s | 90° | 19.88 | 1.04 | 70.18 | 14.51 |
| Example 1-19 | Acetonitrile | N'N-dimethylformamide | 10 | 18% | 10 cm | 1 cm | 2 MPa | 20 mm/s | 90° | 20.33 | 1.07 | 75.82 | 16.49 |
| Example 1-20 | Acetonitrile | N'N-dimethylformamide | 10 | 18% | 20 cm | 1 cm | 2 MPa | 20 mm/s | 90° | 20.16 | 1.08 | 73.59 | 16.02 |
| Example 1-21 | Acetonitrile | N'N-dimethylformamide | 10 | 18% | 25 cm | 1 cm | 2 MPa | 20 mm/s | 90° | 18.47 | 1.12 | 63.11 | 13.06 |
| Example 1-22 | Acetonitrile | N'N-dimethylformamide | 10 | 18% | 15 cm | 3 cm | 2 MPa | 20 mm/s | 90° | 19.58 | 1.01 | 72.29 | 14.30 |
| Example 1-23 | Acetonitrile | N'N-dimethylformamide | 10 | 18% | 15 cm | 0.5 cm | 2 MPa | 20 mm/s | 90° | 20.47 | 1.02 | 71.64 | 14.96 |
| Example 1-24 | Acetonitrile | N'N-dimethylformamide | 10 | 18% | 15 cm | 2 cm | 2 MPa | 20 mm/s | 90° | 21.17 | 1.06 | 75.68 | 16.98 |
| Example 1-25 | Acetonitrile | N'N-dimethylformamide | 10 | 18% | 15 cm | 1 cm | 4 MPa | 20 mm/s | 90° | 23.01 | 1.02 | 75.74 | 17.78 |
| Example 1-26 | Acetonitrile | N'N-dimethylformamide | 10 | 18% | 15 cm | 1 cm | 0.2 MPa | 20 mm/s | 90° | 14.31 | 0.98 | 52.97 | 7.43 |
| Example 1-27 | Acetonitrile | N'N-dimethylformamide | 10 | 18% | 15 cm | 1 cm | 1 MPa | 20 mm/s | 90° | 17.82 | 1.03 | 67.91 | 12.46 |
| Example 1-28 | Acetonitrile | N'N-dimethylformamide | 10 | 18% | 15 cm | 1 cm | 1.5 MPa | 20 mm/s | 90° | 18.88 | 1.03 | 70.43 | 13.70 |
| Example 1-29 | Acetonitrile | N'N-dimethylformamide | 10 | 18% | 15 cm | 1 cm | 2.5 MPa | 20 mm/s | 90° | 22.53 | 1.06 | 72.31 | 17.27 |
| Example 1-30 | Acetonitrile | N'N-dimethylformamide | 10 | 18% | 15 cm | 1 cm | 3 MPa | 20 mm/s | 90° | 22.93 | 1.04 | 75.14 | 17.92 |
| Example 1-31 | Acetonitrile | N'N-dimethylformamide | 10 | 18% | 15 cm | 1 cm | 2 MPa | 80 mm/s | 90° | 4.15 | 1.02 | 25.68 | 1.09 |
| Example 1-32 | Acetonitrile | N'N-dimethylformamide | 10 | 18% | 15 cm | 1 cm | 2 MPa | 5 mm/s | 90° | 19.87 | 1.08 | 76.27 | 16.37 |
| Example 1-33 | Acetonitrile | N'N-dimethylformamide | 10 | 18% | 15 cm | 1 cm | 2 MPa | 15 mm/s | 90° | 21.22 | 1.09 | 79.81 | 18.46 |
| Example 1-34 | Acetonitrile | N'N-dimethylformamide | 10 | 18% | 15 cm | 1 cm | 2 MPa | 25 mm/s | 90° | 22.08 | 1.08 | 78.49 | 18.72 |
| Example 1-35 | Acetonitrile | N'N-dimethylformamide | 10 | 18% | 15 cm | 1 cm | 2 MPa | 35 mm/s | 90° | 19.79 | 1.05 | 71.21 | 14.8 |
| Example 1-36 | Acetonitrile | N'N-dimethylformamide | 10 | 18% | 15 cm | 1 cm | 2 MPa | 45 mm/s | 90° | 17.61 | 1.03 | 64.13 | 11.63 |
| Example 1-37 | Acetonitrile | N'N-dimethylformamide | 10 | 18% | 15 cm | 1 cm | 2 MPa | 55 mm/s | 90° | 15.66 | 1.03 | 57.73 | 9.31 |
| Example 1-38 | Acetonitrile | N'N-dimethylformamide | 10 | 18% | 15 cm | 1 cm | 2 MPa | 70 mm/s | 90° | 7.68 | 1.04 | 34.67 | 2.77 |

**Table 2 Air knife blowing performed after coating**

| | First solvent | Second solvent | Y | Solid content | Distance X2 | Air knife pressure | Air knife moving speed | Air knife angle | Jsc (mA/cm²) | Voc (V) | FF (%) (%) | PCE (%) |
|---|---|---|---|---|---|---|---|---|---|---|---|---|
| Example 2-1 | Acetonitrile | N'N-dimethylformamide | 3 | 18% | 1 cm | 3 MPa | 30 mm/s | 90° | 22.03 | 1.09 | 81.17 | 19.49 |
| Example 2-2 | Dioxane | N'N-diethylacetamide | 3 | 18% | 1 cm | 3 MPa | 30 mm/s | 90° | 21.76 | 1.11 | 79.21 | 19.13 |
| Example 2-3 | Ethylene glycol monomethyl ether | N-methylpyrrolidone | 3 | 18% | 1 cm | 3 MPa | 30 mm/s | 90° | 21.16 | 1.08 | 74.23 | 16.96 |
| Example 2-4 | Acetonitrile | Dimethyl sulfoxide | 3 | 18% | 1 cm | 3 MPa | 30 mm/s | 90° | 21.57 | 1.09 | 77.35 | 18.19 |
| Example 2-5 | N'N-dimethylformamide | γ-butyrolactone | 3 | 18% | 1 cm | 3 MPa | 30 mm/s | 90° | 20.17 | 1.05 | 68.88 | 14.59 |
| Example 2-6 | Acetonitrile | N'N-dimethylformamide | 6 | 18% | 1 cm | 3 MPa | 30 mm/s | 90° | 18.82 | 1.08 | 71.48 | 14.53 |
| Example 2-7 | Acetonitrile | N'N-dimethylformamide | 1 | 18% | 1 cm | 3 MPa | 30 mm/s | 90° | 18.17 | 1.04 | 72.38 | 13.68 |
| Example 2-8 | Acetonitrile | N'N-dimethylformamide | 2 | 18% | 1 cm | 3 MPa | 30 mm/s | 90° | 20.51 | 1.04 | 74.27 | 15.84 |
| Example 2-9 | Acetonitrile | N'N-dimethylformamide | 4 | 18% | 1 cm | 3 MPa | 30 mm/s | 90° | 21.77 | 1.07 | 76.19 | 17.75 |
| Example 2-10 | Acetonitrile | N'N-dimethylformamide | 3 | 40% | 1 cm | 3 MPa | 30 mm/s | 90° | 12.74 | 1.03 | 42.27 | 5.55 |
| Example 2-11 | Acetonitrile | N'N-dimethylformamide | 3 | 10% | 1 cm | 3 MPa | 30 mm/s | 90° | 18.99 | 1.03 | 72.89 | 14.26 |
| Example 2-12 | Acetonitrile | N'N-dimethylformamide | 3 | 15% | 1 cm | 3 MPa | 30 mm/s | 90° | 19.19 | 1.07 | 80.87 | 16.61 |

| | First solvent | Second solvent | Y | Solid content | Distance X2 | Air knife pressure | Air knife moving speed | Air knife angle | Jsc (mA/cm²) | Voc (V) | FF (%) | PCE (%) |
|---|---|---|---|---|---|---|---|---|---|---|---|---|
| Example 2-13 | Acetonitrile | N'N-dimethylformamide | 3 | 20% | 1 cm | 3 MPa | 30 mm/s | 90° | 21.02 | 1.06 | 75.97 | 16.93 |
| Example 2-14 | Acetonitrile | N'N-dimethylformamide | 3 | 25% | 1 cm | 3 MPa | 30 mm/s | 90° | 20.14 | 1.01 | 66.85 | 13.60 |
| Example 2-15 | Acetonitrile | N'N-dimethylformamide | 3 | 30% | 1 cm | 3 MPa | 30 mm/s | 90° | 16.31 | 1.05 | 69.38 | 11.88 |
| Example 2-16 | Acetonitrile | N'N-dimethylformamide | 3 | 18% | 3 cm | 3 MPa | 30 mm/s | 90° | 4.15 | 0.7 | 14.94 | 0.43 |
| Example 2-17 | Acetonitrile | N'N-dimethylformamide | 3 | 18% | 0.5 cm | 3 MPa | 30 mm/s | 90° | 19.75 | 0.97 | 72.81 | 13.95 |
| Example 2-18 | Acetonitrile | N'N-dimethylformamide | 3 | 18% | 2 cm | 3 MPa | 30 mm/s | 90° | 19.01 | 1.06 | 71.44 | 14.40 |
| Example 2-19 | Acetonitrile | N'N-dimethylformamide | 3 | 18% | 1 cm | 6 MPa | 30 mm/s | 90° | 20.17 | 0.95 | 64.73 | 12.40 |
| Example 2-20 | Acetonitrile | N'N-dimethylformamide | 3 | 18% | 1 cm | 0.3 MPa | 30 mm/s | 90° | 7.68 | 0.87 | 16.84 | 1.13 |
| Example 2-21 | Acetonitrile | N'N-dimethylformamide | 3 | 18% | 1 cm | 1 MPa | 30 mm/s | 90° | 18.42 | 1.02 | 53.11 | 9.98 |
| Example 2-22 | Acetonitrile | N'N-dimethylformamide | 3 | 18% | 1 cm | 2 MPa | 30 mm/s | 90° | 19.66 | 1.04 | 74.76 | 15.29 |
| Example 2-23 | Acetonitrile | N'N-dimethylformamide | 3 | 18% | 1 cm | 4 MPa | 30 mm/s | 90° | 19.93 | 1.02 | 71.09 | 14.45 |
| Example 2-24 | Acetonitrile | N'N-dimethylformamide | 3 | 18% | 1 cm | 3 MPa | 80 mm/s | 90° | 17.63 | 0.97 | 73.21 | 12.52 |
| Example 2-25 | Acetonitrile | N'N-dimethylformamide | 3 | 18% | 1 cm | 3 MPa | 5 mm/s | 90° | 15.34 | 1.01 | 43.21 | 6.69 |
| Example 2-26 | Acetonitrile | N'N-dimethylformamide | 3 | 18% | 1 cm | 3 MPa | 15 mm/s | 90° | 18.23 | 1.04 | 69.31 | 13.14 |
| Example 2-27 | Acetonitrile | N'N-dimethylformamide | 3 | 18% | 1 cm | 3 MPa | 25 mm/s | 90° | 19.85 | 1.05 | 74.19 | 15.46 |
| Example 2-28 | Acetonitrile | N'N-dimethylformamide | 3 | 18% | 1 cm | 3 MPa | 35 mm/s | 90° | 20.83 | 1.06 | 73.64 | 16.26 |
| Example 2-29 | Acetonitrile | N'N-dimethylformamide | 3 | 18% | 1 cm | 3 MPa | 45 mm/s | 90° | 21.08 | 1.06 | 71.23 | 15.92 |
| Example 2-30 | Acetonitrile | N'N-dimethylformamide | 3 | 18% | 1 cm | 3 MPa | 55 mm/s | 90° | 19.97 | 1.03 | 74.98 | 15.42 |
| Example 2-31 | Acetonitrile | N'N-dimethylformamide | 3 | 18% | 1 cm | 3 MPa | 70 mm/s | 90° | 18.15 | 0.96 | 75.01 | 13.07 |

| | | | | | | | | | | | | |
|---|---|---|---|---|---|---|---|---|---|---|---|---|
| Note: (1) In Tables 1 and 2, the boiling points and saturated vapor pressures at 20°C of the first solvent and the second solvent are listed as shown in Table 3 below. | | | | | | | | | | | | |

**Table 3**

| First solvent (boiling point, saturated vapor pressure at 20°C) | Second solvent (boiling point, saturated vapor pressure at 20°C) |
|---|---|
| Acetonitrile (82°C, 72.8 mm Hg) | N'N-dimethylformamide (153°C, 2.7 mm Hg) |
| Dioxane (101°C, 27 mm Hg) | N'N-diethylacetamide (166°C, 1.8 mm Hg) |
| Ethylene glycol monomethyl ether (124.5°C, 6.17 mm Hg) | N-methylpyrrolidone (202°C, 0.29 mm Hg) |
| Acetonitrile (82°C, 72.8 mm Hg) | Dimethyl sulfoxide (189°C, 0.42 mm Hg) |
| N'N-dimethylformamide (153°C, 2.7 mm Hg) | γ-butyrolactone (203°C, 0.25 mm Hg) |

(2) In Tables 1 and 2, Y = first solvent/second solvent (volume ratio).

(3) Distance X1 = a distance along a coating direction where an air knife of the air knife process was located behind a slit coating blade.

(4) Distance X2 = a distance between an air knife blade of the air knife process and a coating substrate surface.

(5) Air knife angle = an angle between an air knife of the air knife process and the coating substrate surface.

### 2. Morphology Test

Testing method: A scanning electron microscope (SEM) was used.

### Test samples: Example 1-1 and Example 2-1.

Test results are shown in FIGs. 3 to 5. It can be seen that the samples prepared in Example 1-1 and Example 2-1 have microscopically dense grain sizes with no gaps and few grain boundaries, indicating few defects. In addition, the main grain size distribution is above 1.2 µm, up to a maximum of 2.12 µm, indicating good flatness.

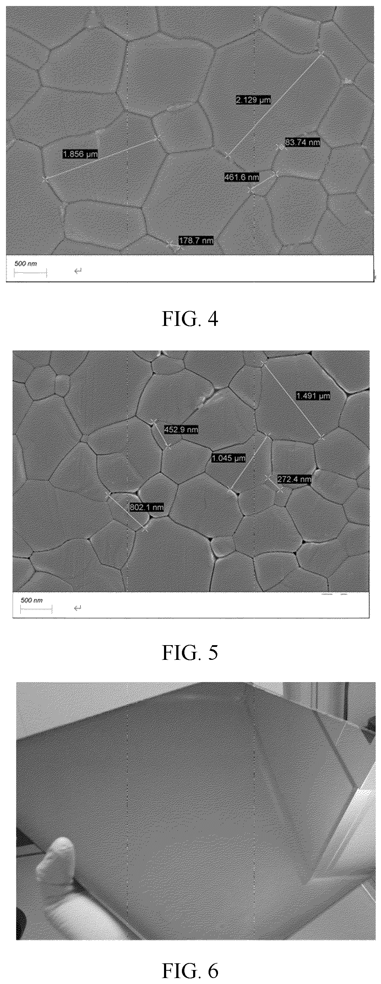

In addition, a photograph of the sample of Example 1-1 is shown in FIG. 6, where a surface thereof exhibits a white haze.

It should be noted that this application is not limited to the foregoing embodiments. The above embodiments are merely examples, and embodiments having substantially the same configuration and achieving the same effects as the technical concepts within the scope of the technical solutions of this application are included in the technical scope of this application. Additionally, without departing from the principle of this application, various modifications that can be conceived by persons skilled in the art applied to the embodiments, and other forms constructed by combining some constituent elements in the embodiments, are also included within the scope of this application.

## Claims

1. A perovskite solar cell, comprising a transparent electrode, a first functional layer, a perovskite film, a second functional layer, and a second electrode layer arranged in a stacked manner, wherein a perovskite grain size distribution in the perovskite film is ≥ 1.2 µm.

2. The perovskite solar cell according to claim 1, wherein the perovskite grain size distribution in the perovskite film is ≥ 2 µm.

3. The perovskite solar cell according to claim 2, wherein the perovskite grain size distribution in the perovskite film is 2 µm to 3 µm.

4. A perovskite precursor solution with a composition comprising a perovskite precursor material and a solvent, wherein the solvent comprises a first solvent and a second solvent, satisfying one or more of the following (1) and (2):
(1) a boiling point of the first solvent is lower than a boiling point of the second solvent; and
(2) a saturated vapor pressure of the first solvent is higher than a saturated vapor pressure of the second solvent.

5. The perovskite precursor solution according to claim 4, wherein the first solvent and the second solvent satisfy one or more of the following (1) and (2):
(1) an absolute value of a difference between the boiling point of the first solvent and the boiling point of the second solvent is ≥ 30; and
(2) the saturated vapor pressure of the first solvent is more than 8 times the saturated vapor pressure of the second solvent.

6. The perovskite precursor solution according to claim 4 or 5, wherein the first solvent satisfies one or more of the following (1) and (2):
(1) the boiling point is 70°C to 160°C; and
(2) the saturated vapor pressure is higher than 2 mm Hg at 20°C.

7. The perovskite precursor solution according to any one of claims 4 to 6, wherein the second solvent satisfies one or more of the following (1) and (2):
(1) the boiling point is 130°C to 220°C; and
(2) the saturated vapor pressure is lower than or equal to 3 mm Hg at 20°C.

8. The perovskite precursor solution according to any one of claims 4 to 7, wherein a volume ratio of the first solvent to the second solvent is Y, and 20 ≥ Y ≥ 1.

9. The perovskite precursor solution according to any one of claims 4 to 8, wherein a solid content of the perovskite precursor solution is 10% to 40%.

10. The perovskite precursor solution according to any one of claims 4 to 9, wherein the first solvent comprises one or more of acetonitrile, dioxane, ethylene glycol monomethyl ether, and N'N-dimethylformamide.

11. The perovskite precursor solution according to any one of claims 4 to 10, wherein the second solvent comprises one or more of N'N-dimethylformamide, N'N-diethylacetamide, N-methylpyrrolidone, dimethyl sulfoxide, and γ-butyrolactone.

12. The perovskite precursor solution according to any one of claims 4 to 11, wherein a general structural formula of the perovskite precursor material is ABX₃ or A₂CDX₆, wherein A is a monovalent cation, B is a divalent metal cation, C and D are a monovalent metal cation and a trivalent metal cation respectively, and X is a monovalent anion.

13. The perovskite precursor solution according to any one of claims 4 to 12, satisfying one or more of the following (1) to (5):
(1) A comprises one or more of Cs⁺, K⁺, Rb⁺, monovalent amine cations, and monovalent amidinium cations;
(2) B comprises one or more of Pb²⁺, Sn²⁺, Fe²⁺, Mn²⁺, Ni²⁺, Ge²⁺, Co²⁺, and Sb²⁺;
(3) C comprises one or more of Cs⁺, Ag⁺, K⁺, and Ru⁺;
(4) D comprises one or more of Bi³⁺, Ni³⁺, Fe³⁺, and Cu³⁺; and
(5) X comprises one or more of I⁻, Br⁻, and Cl-.

14. A preparation method of perovskite solar cell, comprising:
preparing a first functional layer on a surface of a transparent electrode;
preparing a perovskite film on a surface of the first functional layer;
preparing a second functional layer on a surface of the perovskite film; and
preparing a second electrode layer on a surface of the second functional layer;
wherein the preparing a perovskite film on a surface of the first functional layer comprises:
applying a perovskite precursor solution on the surface of the first functional layer through slit coating, and quenching a solvent in the perovskite precursor solution through an air knife process to form an intermediate-state film, wherein the perovskite precursor solution is the perovskite precursor solution according to any one of claims 4 to 13; and
annealing the intermediate-state film to prepare the perovskite film.

15. The preparation method of perovskite solar cell according to claim 14, wherein a volume ratio of the first solvent to the second solvent is Y, the slit coating and the air knife process are performed synchronously, and 20 ≥ Y ≥ 6.

16. The preparation method of perovskite solar cell according to claim 15, wherein the preparation method satisfies one or more of the following (1) to (4):
(1) along a coating direction of the slit coating, an air knife of the air knife process is located 5 cm to 30 cm behind a slit coating blade;
(2) a distance between an air knife blade of the air knife process and the surface of the first functional layer is 0.5 cm to 3 cm;
(3) an air knife pressure of the air knife process is 0.2 MPa to 4 MPa; and
(4) a moving speed of the air knife of the air knife process and the slit coating blade is 5 mm/s to 80 mm/s.

17. The preparation method of perovskite solar cell according to claim 14, wherein a volume ratio of the first solvent to the second solvent is Y, the slit coating and the air knife process are performed sequentially, and 6 ≥ Y ≥ 1.

18. The preparation method of perovskite solar cell according to claim 17, satisfying one or more of the following (1) to (3):
(1) a distance between an air knife blade of the air knife process and the surface of the first functional layer is 0.5 cm to 3 cm;
(2) an air knife pressure of the air knife process is 0.3 MPa to 6 MPa; and
(3) a moving speed of an air knife of the air knife process and a slit coating blade is 5 mm/s to 80 mm/s.

19. An electric apparatus, comprising one or more of the perovskite solar cell according to any one of claims 1 to 3 and a perovskite solar cell prepared using the preparation method according to any one of claims 14 to 18.
